# EUROPEAN PATENT APPLICATION

(11) **EP 3 618 127 A1**
(43) Date of publication of application: **04.03.2020**
(21) Application number: 18792087.1
(22) Date of filing: 26.03.2018
(51) Int. Cl.: H01L 31/0392, H01L 31/05, H01L 31/02

(54) **CURVED SOLAR CELL MODULE**

(30) Priority: 24.04.2017 KR 20170052517
(71) Applicant: LG Electronics Inc., Seoul 07336 (KR)
(72) Inventor: JEON, Joonho, Seoul 08592 (KR); KIM, Jungguen, Seoul 08592 (KR); SONG, Yong, Seoul 08592 (KR); WOO, Jeonghun, Seoul 08592 (KR); HWANG, Eonjoo, Seoul 08592 (KR)
(74) Representative: Mooser, Sebastian Thomas
(86) International application number: PCT/KR2018/003531
(87) International publication number: WO 2018/199481

(57) **Abstract**

A curved solar cell module according to an embodiment of the present disclosure includes a curved transparent substrate including a first region having a first curvature and a second region having a second curvature different from the first curvature, a first output unit including a plurality of first solar cells disposed along the first curvature at the first region and having a first slope and connected to each other, and a first optimizer connected to the plurality of first solar cells to adjust output power thereof, a second output unit including a plurality of second solar cells disposed along the second curvature at the second region and having a second slope different from the first slope and electrically connected to each other, and a second optimizer connected to the plurality of second solar cells to adjust output power thereof, and a connection unit connecting between the first output unit and the second output unit.

## Description

### [Technical Field]

The present disclosure relates to a curved solar cell module installed and used on a curved surface.

### [Background Art]

Recently, as existing energy sources such as petroleum and coal are expected to be depleted, interests in alternative energy sources for replacing the existing energy sources are increasing. Among them, solar cells are producing electric energy from solar energy and are attracting attention because they are rich in energy resources and have no problems with environmental pollution.

A typical solar cell includes a substrate and an emitter layer made of semiconductors of different conductive types, such as p-type and n-type, and an electrode connected to the substrate and the emitter layer, respectively. At this time, p-n junction is formed in an interface of the substrate and the emitter layer.

When light is incident on this solar cell, a plurality of electron-hole pairs are generated in the semiconductor, the generated electron-hole pairs are separated into electrons and holes, the electrons and the holes move toward n-type and p-type semiconductors, for example, the emitter layer and the substrate, respectively, the electrons and the holes are collected by electrodes electrically connected to the substrate and the emitter layer, and these electrodes are connected by wires to obtain power.

Such a solar cell has been used by packaging a plurality of solar cells in a module form in order to increase the output power.

In recent years, such a solar cell module has been satisfying consumer needs in various forms, such as being supplied to solar power plants or homes.

The solar cells installed in the solar cell module may be connected in series to each other (for example, a string). When the output current of one solar cell included in the string is lower, the total output current of the string converges to the lowest output current value due to characteristics of the series circuit. In such a case, since the output current value of the solar cell module converges to the minimum value, there arises a problem that the output of the entire module is lowered.

On the other hand, when the solar cell module is used in a roof of a vehicle, a wing of an airplane, an exterior of a building, or the like, having a curved shape, the solar cell module is also installed to have a curved surface in accordance with the installation place.

However, in this case, due to the shape of the curved surface itself, since the installation angle of the solar cell is changed, the value of the current generated by the solar cell must be changed depending on the position, and as a result, there is a problem that the output of the solar cell module falls.

### [Detailed Description of Invention]

### [Technical Problem]

The present disclosure has been made in view of the above technical background, and improves the overall output of the curved solar cell module by efficiently managing the output of the solar cells disposed along the curved surface.

### [Technical Solution]

A curved solar cell module according to an embodiment of the present disclosure includes a curved transparent substrate including a first region having a first curvature and a second region having a second curvature different from the first curvature, a first output unit including a plurality of first solar cells disposed along the first curvature at the first region and having a first slope and connected to each other, and a first optimizer connected to the plurality of first solar cells to adjust output power thereof, a second output unit including a plurality of second solar cells disposed along the second curvature at the second region and having a second slope different from the first slope and electrically connected to each other, and a second optimizer connected to the plurality of second solar cells to adjust output power thereof, and a connection unit connecting between the first output unit and the second output unit.

A curved solar cell module according to an another embodiment of the present disclosure includes a curved transparent substrate including a first region and a second region different from the first region, a first output unit including a plurality of first solar cells disposed to have a slope in a first direction along the curved surface at the first region, and a first optimizer connected to the plurality of first solar cells to adjust output power thereof, a second output unit including a plurality of second solar cells disposed to have a slope in a second direction different from the first direction at the second region, and a second optimizer connected to the plurality of second solar cells to adjust output power thereof, and a connection unit connecting between the first output unit and the second output unit.

### [Advantageous Effects]

In an embodiment of the present disclosure, the strings are divided for each region and connected to an optimizer that adjusts output power to configure an output unit. Therefore, even though the solar cells form an m × n matrix, the output power of each solar cell can be adjusted for each region having a different slope angle, and as a result, the output power of the entire module can be effectively adjusted.

### [Description of Drawings]

FIG. 1 illustrates a curved solar cell module installed on a roof of a vehicle according to an embodiment of the present disclosure.
FIG. 2 shows a transparent substrate constituting a curved solar cell module.
FIG. 3 illustrates a state in which a plurality of solar cells are disposed by cutting a curved solar cell module in a column direction, and a traveling direction of light incident on a curved solar cell module according to a position of the sun.
FIG. 4 is a view for illustrating a slope of a solar cell according to a region.
FIG. 5 is a view for explaining an arrangement of a solar cell and a configuration of an output unit according to an embodiment of the present disclosure.
FIG. 6 is a view for explaining a configuration in which a first region is divided into a plurality.
FIG. 7 is a view illustrating a state in which a plurality of solar cells are disposed by cutting a curved solar cell module in a row direction.
FIG. 8 is a view for explaining an arrangement of a solar cell and a configuration of an output unit according to FIG. 7.
FIGS. 9 and 10 are views for explaining solar cells in which a slope direction is different in a column direction.
FIG. 11 is a view for explaining an arrangement of a solar cell and a configuration of an output unit according to FIG. 10.
FIG. 12 is a view for explaining solar cells in which a slope direction is different in a row direction.
FIG. 13 is a view for explaining an arrangement of a solar cell and a configuration of an output unit according to of FIG. 12.

### [Mode for Invention]

Hereinafter, embodiments of the present disclosure will be described in detail so that those skilled in the art may easily implement the present disclosure with reference to the accompanying drawings.

However, the present disclosure may be embodied in many different forms and should not be construed as limited to the embodiments set forth herein. In the drawings, parts irrelevant to the description may be simply or omitted in order to clearly describe the present disclosure. In addition, various embodiments shown in the drawings are presented by way of example, and are shown by simplifying the components unlike the actual for convenience of description.

In the following detailed description, the same reference numerals are assigned to the same components having no difference according to embodiments, and the description thereof will not be repeated.

In the following description of the embodiment, a curved solar cell module according to an embodiment of the present disclosure is described in an embodiment installed on a roof of a vehicle, but can be used to be installed on an appearance, such as a roof of a building, or a body of an airplane. Hereinafter, a solar cell according to the present disclosure will be described with reference to the accompanying drawings.

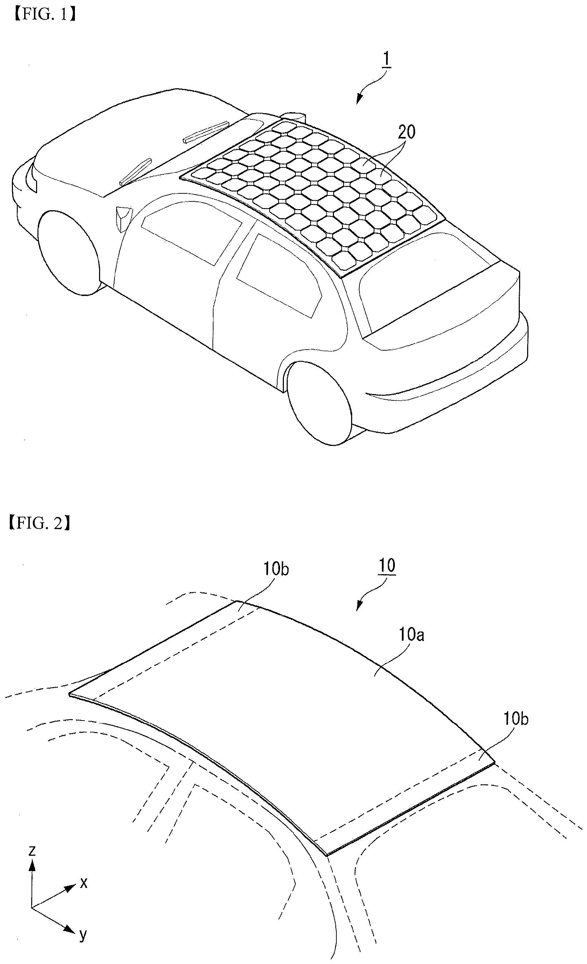

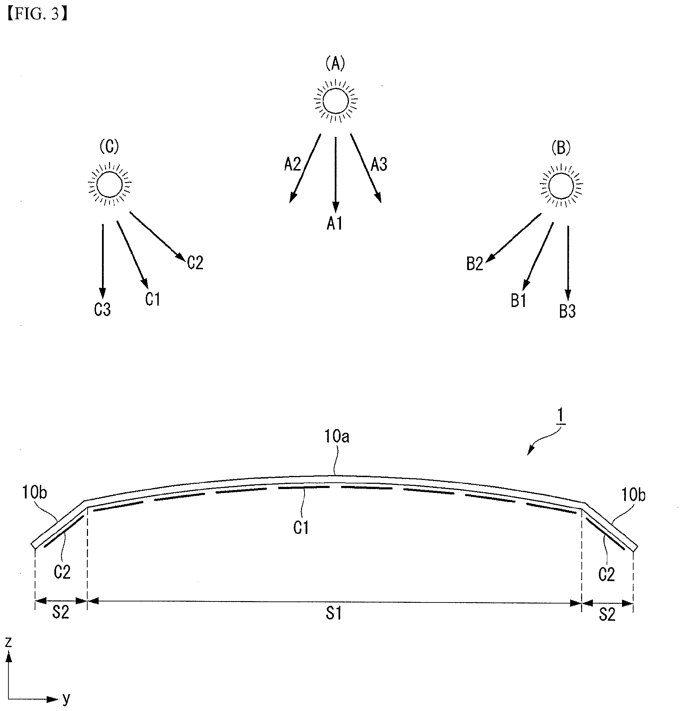

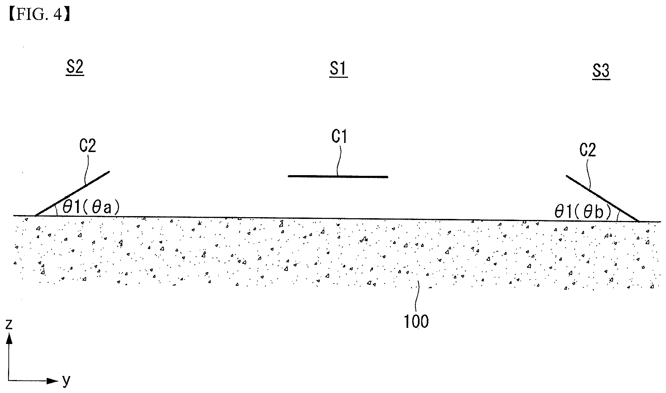

FIGS. 1 and 2 illustrate a curved solar cell module installed on a roof of a vehicle according to an embodiment of the present disclosure, and FIG. 2 shows a transparent substrate constituting the curved solar cell module. FIG. 3 illustrates a state in which a plurality of solar cells are disposed by cutting the curved solar cell module in a column direction (y-axis direction in the drawing), and a traveling direction of light incident on the curved solar cell module according to a position of the sun. FIG. 4 is a view for illustrating a slope of a solar cell according to a region.

Referring to these drawings, a curved solar cell module 1 according to an embodiment of the present disclosure may be installed on a roof of a vehicle having a curved surface to produce electricity for driving the vehicle.

Modern cars are designed to use a lot of curved surfaces to reduce air resistance and improve the design. The roof of the vehicle also has a generally convex shape at the top, and a part connected to the vehicle body may be formed to have a larger curved surface than other parts.

The curved solar cell module 1 according to an embodiment of the present disclosure should be formed to have at least two different curved surfaces to correspond to the shape of the roof. Therefore, a curved shape of the curved solar cell module 1, in particular, a transparent substrate 10 forming the external appearance may be variously modified according to a radius of curvature, a shape of a curved surface, and the like depending on an object to be installed.

In the embodiment, solar cells 20 may form an m×n matrix (m and n are natural numbers) in rows and columns such that a large number can be disposed on the roof. The connection between the solar cells 20 is configured to be physically connected to each other only within a string, which will be described in detail later. Here, if the columns are in a first direction and the rows are in a second direction, the roof of the vehicle has an approximately-rectangular shape in which the columns are longer than the rows, and thus the solar cells are preferably disposed accordingly. That is, it may be preferable that the solar cells may be disposed such that the number of solar cells arranged in the first direction (y-axis direction in the drawing) on a basis of one column is greater than the number of solar cells arranged in the second direction (x-axis direction in the drawing) on a basis of one row.

The transparent substrate 10 may have an approximately-rectangular shape in which a longitudinal direction (in the y-axis direction in the drawing, hereinafter referred to as the first direction) of the vehicle is longer than a width direction (in the x-axis direction in the drawing, hereinafter referred to as the second direction) of the vehicle.

In addition, the transparent substrate 10 may have a rounded shape bulging upward with respect to the ground 100 as a whole, and in particular, may have a different curvature (or curved surface) according to its position.

As shown, the transparent substrate 10 may be divided into a first region S1 having a first curvature and a second region S2 having a second curvature greater than the first curvature so as to correspond to the roof shape of the vehicle. Thus, the transparent substrate 10 may be composed of a first curved surface 10a having the first curvature at the first region S1, and a second curved surface 10b having the second curvature at the second region S2. Here, since the curvature of the second curved surface 10b is different from the curvature of the first curved surface 10a, the second curved surface 10b may be configured to have a different slope. For example, if the curvature of the second curved surface 10b is large, it may have a steeper slope than the first curved surface 10a, and if the curvature of the second curved surface 10b is small, it may have a smaller slope than the first curved surface 10a.

In a preferred form, the second region S2 may be an edge region including a side part of the transparent substrate 10 on which the roof is connected to the vehicle body, and the first region S1 may be a central region between the second regions S2. Here, since the regional division of the transparent substrate 10 is a theoretical classification according to the curvature, it may not be partitioned as illustrated in the drawing. What is illustrated in the drawings only describes examples. Therefore, the first region S1 illustrated in the drawing may not necessarily correspond to the center of the transparent substrate 10, and the second region S2 may not correspond to the edge of the transparent substrate 10.

Since the solar cells 20 are arranged in accordance with the curved surface of the transparent substrate 10, the slopes of the solar cells 20 may vary according to the regions. Referring to FIG. 4, it may be assumed that first solar cells C1 disposed at the first region S1 converge on a plane because the curvature of the transparent substrate 10 is small, so that the first solar cells C1 may be parallel to the ground 100. In comparison to this, second solar cells C2 disposed at the second region S2 having a greater curvature or a large curved surface than the first region S1 may be installed to slope with respect to the ground 100 than the first solar cells C1.

In the second region S2, since the transparent substrate 10 is positioned to slope with respect to the ground 100 in accordance with the curved surface of the transparent substrate 10, the second solar cell C2 may slope by a first angle θ1 with respect to the ground 100. In addition, a slope angle of the second region S2 may be different. That is, when the slope angle of the second region S2 positioned near the front of the vehicle and the slope angle the second region S2 positioned near the back of the vehicle are referred to as a first angle θa and a second angle θb, respectively, the first angle θa and the second angle θb may be different from each other.

Here, the first and second solar cells C1 and C2 are used to distinguish solar cells belonging to the first region S1 and the second region S2 among solar cells arranged in an m×n matrix. That is, the first solar cells C1 refer to solar cells disposed in a region having a small curvature and the second solar cells C2 refer to solar cells disposed in a region having a greater curvature than the first solar cells C1 and disposed to slope than the first solar cells C1.

Since the solar cells 20 have different slope angles according to positions, the amount of light incident on the solar cells may be different.

Referring to FIG. 3, it is assumed that light enters the curved solar cell module 1 through first to third paths A1 to A3 at a point (A). Here, the first path A1 refers to a path substantially perpendicular to the first region S1, and the second and third paths A2 and A3 refer to paths of light incident to the second region S2 positioned at both sides of the first region S1.

The light traveling along the first path A1 at the point (A) is incident perpendicularly to the first solar cell C1, on the other hand, since the second solar cell C2 slope, the light may be incident obliquely. Therefore, the amount of the light incident on the first solar cell C1 may be greater than that of the light incident on the second solar cell C2.

At a point (B), it is assumed that light enters the curved solar cell module 1 through first to third paths B1 to B3. Here, the first path B1 refers to a path of light directly directed to the first region S1, and the second and third paths B2 and B3 refer to paths of light toward the second region S2 and the third region S3, respectively. The light traveling along the first to third paths B1 to B3 reaches the first solar cell C1, on the other hand, some light does not reach properly to the second solar cell C2 due to the slope. Therefore, the amount of the light incident on the first solar cell C1 may be greater than that of the light incident on the second solar cell C2.

Similarly, at a point (C), light may be less incident on the second solar cell C2 disposed to slope than the first solar cell C1 having no slope.

When light enters the solar cells C1 to C3 as described above, a current value output from the second solar cell C2 is less than a current value output from the first solar cell C1, due to deviation of the output current value, the output current of the module is determined at a lowest output current value by characteristics of a series circuit, and the efficiency of the curved solar cell module 1 may be reduced.

In order to prevent such a problem, the curved solar cell module 1 of the embodiments is configured to control the output for each of the solar cells C1 and C2. This will be described in detail with reference to the accompanying drawings.

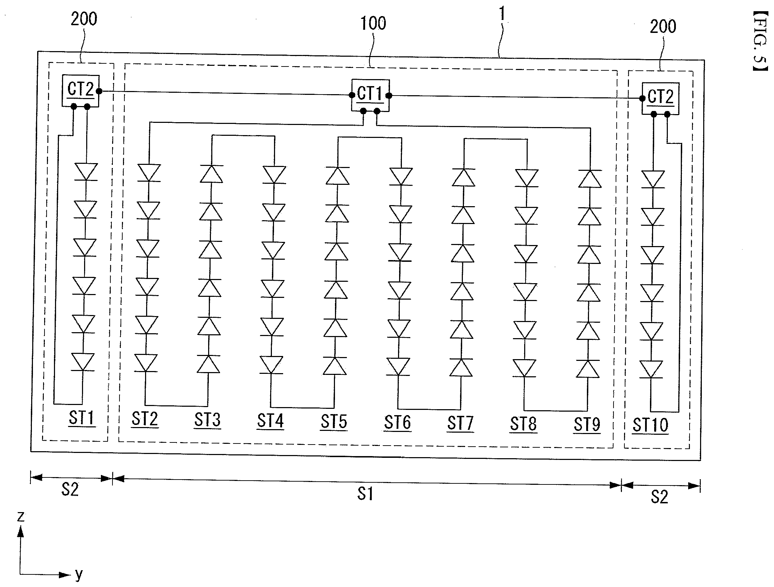

FIG. 5 is a view for explaining an arrangement of a solar cell of a curved solar cell module and a configuration of an output unit according to an embodiment of the present disclosure.

A curved solar cell module 1 according to an embodiment of the present disclosure includes a first output unit 100 including a plurality of first solar cells C1 disposed along a first curvature at a first region S1 and having a first slope and connected to each other, and a first optimizer CT1 connected to the plurality of first solar cells C1 to adjust output power thereof, and a second output unit 200 including a plurality of second solar cells C2 disposed along a second curvature at a second region S2 and having a second slope different from the first slope and electrically connected to each other, and a second optimizer CT2 connected to the plurality of second solar cells C2 to adjust output power thereof.

The optimizers CT1 and CT2 periodically monitor an input power generated by a connected string, when the input power of a current period is lower than that of a past period operate, and actively increase the power of the current period. The optimizers CT1 and CT2 include, for example, buck converter circuits, when the input power drops, change the duty of the converter to find MPPT and reduce the voltage V, and on the other hand, raise the current I to prevent the input power from falling.

In FIG. 5, the solar cells 20 are connected to each other in series in a row direction (z-axis direction in the drawing) to form first to tenth strings ST1 to ST10, and form an m×n matrix as a whole.

Here, the solar cells are preferably connected in the row direction (z-axis direction in the drawing) rather than in a column direction (y-axis direction in the drawing). By arranging the first to tenth strings ST1 to ST10 by connecting the solar cells, the output of the solar cells can be individually adjusted according to the regions S1 and S2.

That is, in case that strings are formed by connecting the solar cells arranged in the column direction (y-axis direction in the drawing), and a part of the strings is positioned in the second region S2, and the other part is positioned in the first region S1. For this reason, it is virtually impossible to control the output of the solar cell for each region S1 and S2. However, when the solar cells are connected in the row direction (z-axis direction in the drawing) as in this embodiment, the string can be positioned in only one region, so that it is possible to control the power of the solar cell for each region S1 and S2.

As described above, in this embodiment, the strings are formed by connecting the solar cells in the row direction (z-axis direction in the drawing). Thus, in the solar cells arrayed in the m×n matrix, the number of the solar cells belonging toone string may be less than the number of the strings.

On the other hand, since the first string ST1 and the tenth string ST10 each are formed by the second solar cells C2 disposed in the second region S2, the solar cells C2 belonging to the first string ST1 and the tenth string ST10 are installed to have a predetermined slope angle θ1. Since the second to ninth strings ST2 to ST9 are formed by the first solar cells C1 disposed in the first region S1, the solar cells C1 belonging to the second to ninth strings ST2 to ST9 may be installed without a slope. Here, the second to ninth strings ST2 to ST9 may be connected in series to each other.

Accordingly, the magnitude of the power generated by the first string ST1 and the tenth string ST10 may be less than that of the power generated by the second to ninth strings ST2 to ST9, respectively. The power output from the first string ST1 and the tenth string ST10 is managed separately from the second to ninth strings ST2 to ST9 to prevent the total output power of the curved solar cell module 1 from falling.

To this end, the second optimizer CT2 may be connected to the first string ST1 and the tenth string ST10 to form the second output unit 200, and the first optimizer CT1 may be connected to the second to ninth strings ST2 to ST9 to form the first output unit 100.

The first optimizer CT1 and the second optimizer CT2 may be connected in series or in parallel by a connection unit 300.

As described above, the curved solar cell module 1 of this embodiment is configured such that the solar cell module is independently generated for each region, and the power output by the control of the controller can be adjusted. For this reason, it can be prevented that the output power of the entire module falls by the second solar cell C2 disposed at the second region S2 which fluctuates in generation amount.

The optimizer CT1 periodically monitors the power output from the first string ST1 or the tenth string ST10, when the input power of a current period is lower than that of a past period, and increases actively the power of the current period and input it to the second optimizer CT2 through the connection unit 300, to control the total output power of the curved solar cell module falling by the first and tenth string ST1, ST10.

On the other hand, the number of the solar cells connected to the first optimizer CT1 may be greater than the number of the solar cells connected to the second optimizer CT2. Thus, it may be desirable that a processing capacity of the first optimizer CT1 may be greater than a processing capacity of the second optimizer CT2. Here, a large processing capacity means that the maximum value of an input value and an output value is large. For example, the magnitude of the voltage and current input to the first optimizer CT1 may be greater than that to the second optimizer CT2, and in addition, the magnitude of the voltage and current output from the first optimizer CT1 may also be greater than that from the second optimizer CT2.

On the other hand, in the curved solar cell module 1 illustrated in FIG. 5, the first region S1 has been described as being composed of one region, however, by forming a plurality of regions, it is possible to more effectively manage the output power of the solar cells disposed in the first region S1.

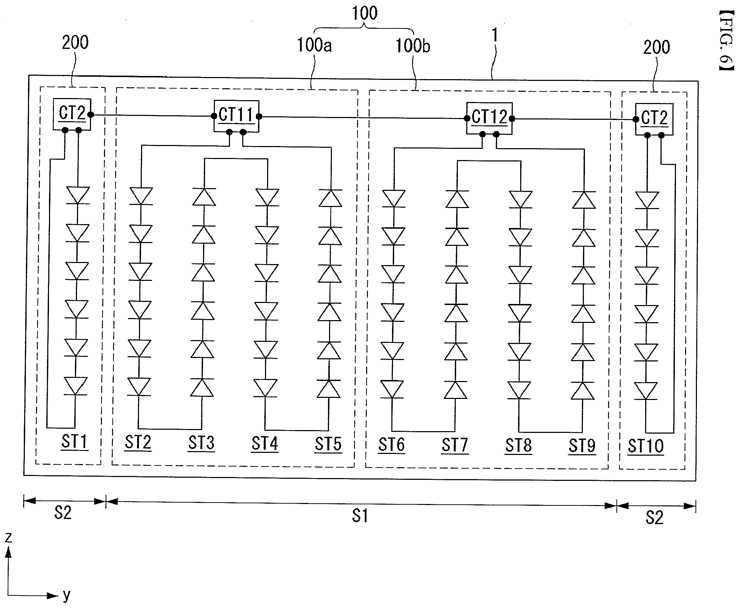

FIG. 6 is a view illustrating that a first region S1 is divided into an eleventh region and a twelfth region.

In FIG. 6, the first region S1 may be further divided into an eleventh region S11 and a twelfth region 12. Here, the eleventh region S11 and the twelfth region S12 may have the same area or different areas, and the division of the region is preferably divided along the row direction (z-axis direction in the drawing). In addition, solar cells disposed in the eleventh region S11 and the twelfth region S12 may be installed to have the same slope angle or different slope angles.

In addition, the first output unit 100 may include an eleventh output unit 100a and a twelfth output unit 100b in accordance with the divided region, and may be configured to adjust the output power for each of the divided regions S11 and S12.

In the eleventh region S11, the second to fifth strings ST2 to ST5 are connected in series by forming a string set, and connected to the eleventh optimizer CT11 to form the eleventh output unit 100a. In the twelfth region S12, the sixth to ninth strings ST6 to ST9 are also connected in series by forming a string set, and connected to the twelfth optimizer CT12 to form the twelfth output unit 100b.

The plurality of optimizers CT2, CT11, and CT12 may be configured to be connected to each other by the connection unit 300. Here, processing capacities of the eleventh optimizer CT11, the twelfth optimizer CT12, and the second optimizer CT2 may be determined according to the number of strings connected to each optimizer. As the number of strings decreases, the size of the processing capacity also decreases, and as the number of strings increases, the size of the processing capacity also increases.

In the curved solar cell module 1 of this embodiment, the solar cells are arranged in an m×n matrix, but are divided into the eleventh region S11, the twelfth region S12, and the second region S2 to generate power, even if the generated power in some regions drops, since the optimizer operates to compensate for the dropped power, the output power of the entire module can be prevented from falling.

On the other hand, in the above-described embodiment, when the curved transparent substrate 10 includes the first region S1 having the first curvature and the second region S2 having the second curvature different from the first curvature in the y-axis direction in the drawing, the arrangement of the solar cells and the configuration of the output unit have been described.

Hereinafter, when the curved transparent substrate 10 includes a first region S1 having a first curvature and a second region S2 having a second curvature different from the first curvature in the x-axis direction in the drawing, an embodiment is described.

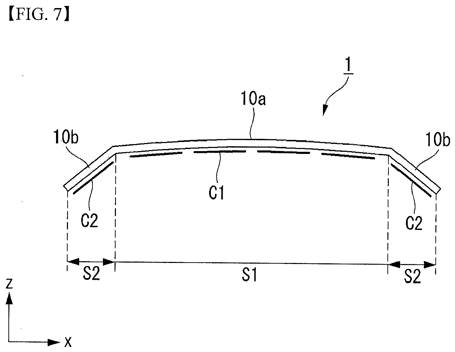

As illustrated in FIG. 7, the transparent substrate 10 can be divided into a first region S1 having a first curvature and a second region S2 having a second curvature greater than the first curvature in the x-axis direction in the drawing. Accordingly, the transparent substrate 10 may be composed of a first curved surface 10a having a first curvature in the first region S1 and may be composed of a second curved surface 10b having a second curvature in the second region S2.

In addition, solar cells disposed along the first curved surface and the second curved surface may include a first solar cell C1 having a first slope and a second solar cell C2 having a second slope greater than the first slope.

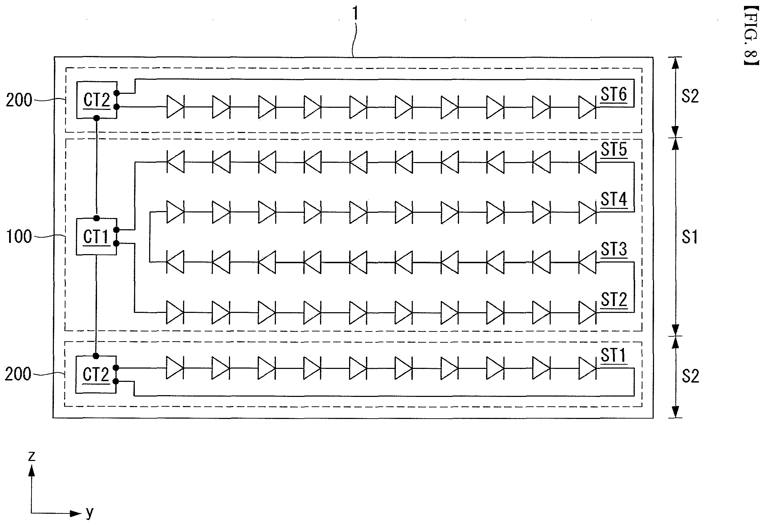

The arrangement of the solar cells and the configuration of the output unit will be described with reference to FIG. 8.

In FIG. 8, first solar cells C1 having different slopes are disposed to form an m×n matrix. Here, the first region S1 and the second region S2 may be divided along a longitudinal direction of strings ST1 to ST6. By partitioning the first region and the second region in this manner, the string can be positioned in only one of the first and second regions.

The first solar cells C1 positioned in the first region S1 and the second solar cells C2 positioned in the second region S2 may be disposed together to form an m×n matrix. The first string ST1 and the sixth string ST6 may be positioned in the second region S2, and the second to fifth strings ST2 to ST5 may be positioned in the first region S1. Here, the second to fifth strings ST2 to ST5 may be connected in series.

A first optimizer CT1 may be connected to the second to fifth strings ST2 to ST5, and a second optimizer CT2 may be connected to the first and sixth strings ST1 and ST6, respectively. The first and second optimizers CT1 and CT2 have a configuration connected by a connection unit 300.

In this embodiment, the longitudinal direction of the string is parallel to the column direction (y-axis direction in the drawing) of the solar cells forming an m×n matrix array. Therefore, the number of solar cells belonging to each of the strings ST1 to ST6 can be increased than in the previous embodiment.

In addition, the solar cells 20 may have different slope directions depending on positions even if the curved transparent substrate is formed to have the same curved surface. If the slope direction of solar cell is different, the amount of light incident on the solar cell may be changed at a position, and thus may lower the total output power of the module. Hereinafter, the configuration of the output unit according to a case having a slope in different directions and the arrangement relationship of the solar cell accordingly will be described.

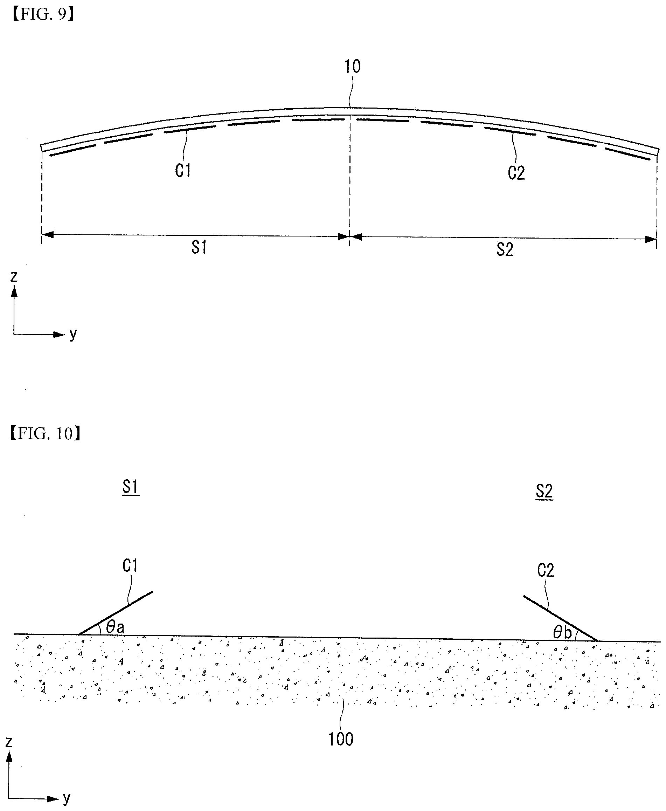

First, referring to FIGS. 9 and 10, a curved transparent substrate 10 having a constant curvature may have left and right symmetrical shapes with respect to a vertex. Therefore, some of solar cells disposed along a curved surface, that is, a first solar cell C1 may be installed to have a first angle θa having an uphill slope in a first region S1, and a second solar cell C2 may be installed to have a second angle θb having a downhill slope in a second region S2.

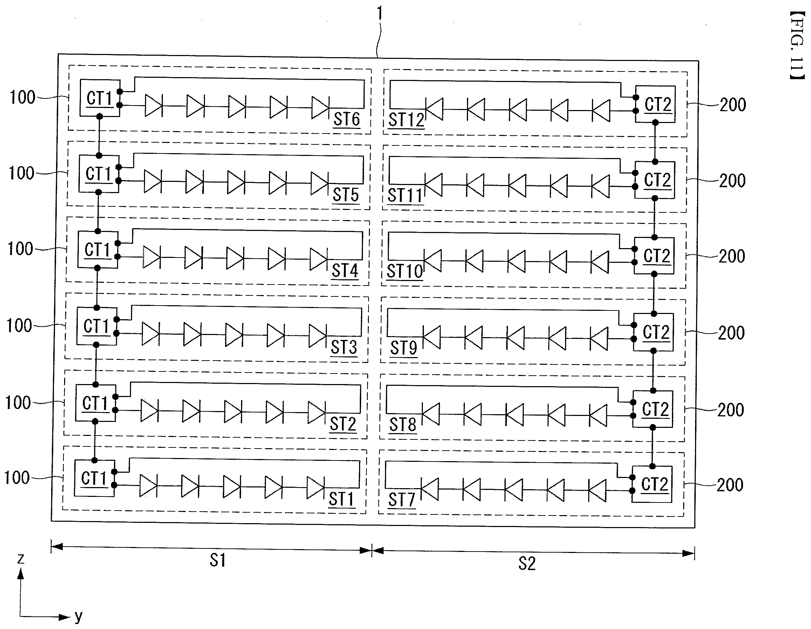

FIG. 11 illustrates an arrangement of solar cells and a configuration of an output unit according to FIG. 10.

Referring to FIG. 11, first solar cells and second solar cells may be disposed together to form an m×n matrix.

In a first region S1 and a second region S2, a first solar cell C1 and a second solar cell C2 form a plurality of strings, respectively. In the first region S1, the first solar cell C1 may form a plurality of strings ST1 to ST6 by individually connecting a plurality of solar cells in a column direction (y-axis direction in the drawing) belonging to the first region S1. Each of the strings string ST1 to ST6 may be connected to a first optimizer CT1 to configure a first output unit 100. Accordingly, a plurality of first output units 100 may be formed in the first region S1.

In addition, in the second region S2, the second solar cell C2 may include a plurality of solar cells in the column direction belonging to the second region S2 to form a string ST7 to ST12, respectively. Each of the strings ST7 to ST12 may be connected to a second optimizer CT2 to form a plurality of second output units 200.

Accordingly, the strings ST1 to ST6 belonging to the first region S1 are positioned on the same line as the strings ST7 to ST12 belonging to the second region S2 in the y-axis direction in the drawing.

Thus, the first and second solar cells may form the first and second output units together in the m×n matrix array, and the optimizer may operate for each output unit to be adjusted so that the output power is not lowered. As a result, the output power of the entire module can be prevented from falling.

Here, the solar cells arranged in the column direction (y-axis direction in the drawing) form the first and second output units belonging to the first region S1 and the second region S2, respectively, on the other hand, a plurality of output units are formed along the row direction (z-axis direction in the drawing). Therefore, the number of solar cells belonging to each string may be less than the total number of strings. In addition, since the number of solar cells connected to each of the optimizers CT1 and CT2 is the same for each output unit, the capacity of the optimizers CT1 and CT2 of all the output units may be the same.

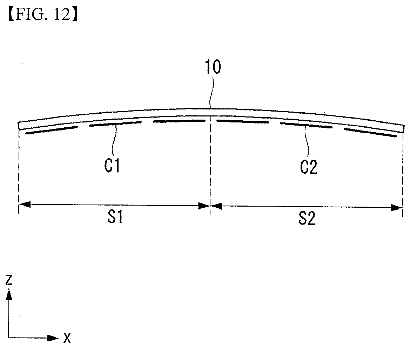

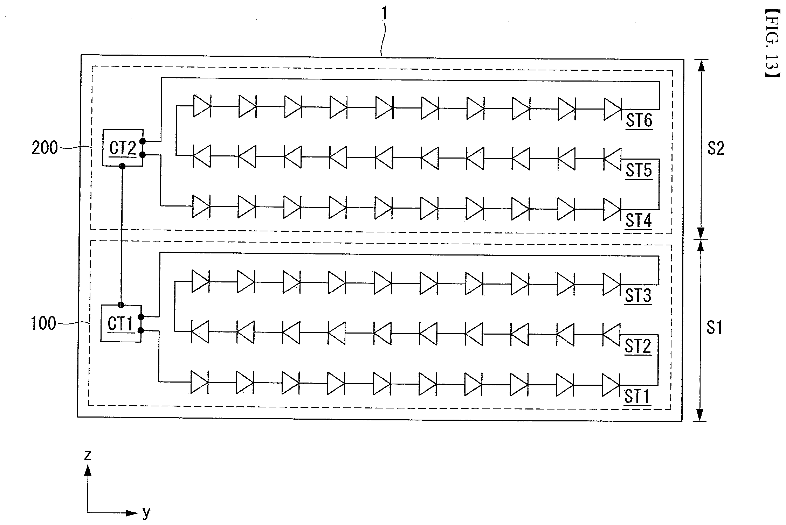

The above embodiments have described embodiments of a case in which the slope directions of the solar cells disposed in the column direction (y-axis direction in the drawing) on the curved transparent substrate 10 are different. Hereinafter, embodiments of a case in which the slope directions of the solar cells disposed in the row direction (x-axis direction in the drawing) are different will be described with reference to FIGS. 12 and 13.

In FIG. 12, since a curved transparent substrate 10 is configured to have the same curved surface in the row direction (x-axis direction in the drawing), the curved transparent substrate 10 may have left and right symmetrical shapes with respect to a vertex.

Accordingly, a first solar cell C1 disposed in a first region S1 may be installed to have an uphill slope, and a second solar cell C2 disposed in a second region S2 may be installed to have a downhill slope.

FIG. 13 illustrates an arrangement of solar cells and a configuration of an output unit according to FIG. 12.

In FIG. 13, the first solar cells and the second solar cells may be disposed together to form an m×n matrix.

In the first region S1, the first solar cells may be connected in a column direction to form a plurality of strings ST1 to ST3, and may be connected to a first optimizer CT1 to form a first output unit 100. In the second region S2, the second solar cells may be also connected in the column direction to form a plurality of strings ST4 to ST6, and may be connected to a second optimizer CT2 to form a second output unit 200.

Accordingly, each of the first optimizer CT1 and the second optimizer CT2 may be connected to a plurality of string sets in which strings are connected in series. On the other hand, in FIG. 13, the number of strings connected to each of the first optimizer CT1 and the second optimizer CT2 is the same, but the present disclosure is not limited thereto.

Although the embodiment of the present disclosure has been described in detail above, the scope of the present disclosure is not limited thereto. Various modifications and improvements of those skilled in the art using the basic concepts of the present disclosure as defined in the following claims belong to the scope of the present disclosure.

## Claims

1. A curved solar cell module comprising:
a curved transparent substrate including a first region having a first curvature and a second region having a second curvature different from the first curvature;
a first output unit including a plurality of first solar cells disposed along the first curvature at the first region and having a first slope and connected to each other, and a first optimizer connected to the plurality of first solar cells to adjust output power thereof;
a second output unit including a plurality of second solar cells disposed along the second curvature at the second region and having a second slope different from the first slope and electrically connected to each other, and a second optimizer connected to the plurality of second solar cells to adjust output power thereof; and
a connection unit connecting between the first output unit and the second output unit.

2. The curved solar cell module of claim 1, wherein the second curvature is greater than the first curvature.

3. The curved solar cell module of claim 1, wherein the second slope is greater than the first slope.

4. The curved solar cell module of claim 1, wherein a number of the plurality of first solar cells connected to the first optimizer is greater than a number of the plurality of second solar cells connected to the second optimizer.

5. The curved solar cell module of claim 1, wherein a processing capacity of the first optimizer is greater than a processing capacity of the second optimizer.

6. The curved solar cell module of claim 1, wherein the curved transparent substrate is divided into the first region and the second region based on a reference line in a first direction to which each of the plurality of first and second solar cells are connected.

7. The curved solar cell module of claim 6, wherein the plurality of first solar cells and the plurality of second solar cells are disposed together to form an m×n matrix, and
a total number of strings disposed in the first region and the second region is greater than a number of the plurality of first or second solar cells belonging to each string.

8. The curved solar cell module of claim 7, wherein a number of the strings disposed in the first region is greater than a number of the strings disposed in the second region.

9. The curved solar cell module of claim 8, wherein the strings disposed in the first region include a plurality of strings connected in series to each other, and
the plurality of strings are connected to a single first optimizer.

10. The curved solar cell module of claim 8, wherein the strings disposed in the first region include a plurality of string sets in which at least two neighboring strings are connected in series, and
the first optimizer includes a plurality of optimizers each connected to the plurality of string sets.

11. The curved solar cell module of claim 1, wherein the plurality of first solar cells are electrically connected to the plurality of second solar cells only by the first and second optimizers.

12. The curved solar cell module of claim 6, wherein the plurality of first solar cells and the plurality of second solar cells are disposed together to form an m×n matrix, and
a total number of strings disposed in the first region and the second region is smaller than a number of the plurality of first or second solar cells belonging to each string.

13. The curved solar cell module of claim 1, wherein the second region is an edge region including side surfaces of the curved transparent substrate.

14. A curved solar cell module comprising:
a curved transparent substrate including a first region and a second region different from the first region;
a first output unit including a plurality of first solar cells disposed to have a slope in a first direction along the curved surface at the first region, and a first optimizer connected to the plurality of first solar cells to adjust output power thereof;
a second output unit including a plurality of second solar cells disposed to have a slope in a second direction different from the first direction at the second region, and a second optimizer connected to the plurality of second solar cells to adjust output power thereof; and
a connection unit connecting between the first output unit and the second output unit.

15. The curved solar cell module of claim 14, wherein the plurality of first solar cells and the plurality of second solar cells are disposed together to form an m×n matrix

16. The curved solar cell module of claim 15, wherein each of the plurality of first solar cells and the plurality of second solar cells forms a string connected in series, and
the string is connected to a single first optimizer and a single second optimizer.

17. The curved solar cell module of claim 16, wherein the first region and the second region partition the curved transparent substrate in a direction crossing a longitudinal direction of the string.

18. The curved solar cell module of claim 17, wherein the first output unit located in the first region and the second output unit located in the second region each include a plurality.

19. The curved solar cell module of claim 18, wherein each of the plurality of first and second solar cells is connected in series at the corresponding first or second output unit to form a string, and
a string disposed in the first region and a string disposed in the second region are located on the same line in the longitudinal direction of the string.

20. The curved solar cell module of claim 19, wherein a total number of the strings is greater than a number of the plurality of first or second solar cells belonging to the strings.
